# EUROPÄISCHE PATENTSCHRIFT

(11) **EP 2 013 923 B1**
(45) Veröffentlichungstag und Bekanntmachung des Hinweises auf die Patenterteilung: **10.10.2012**
(21) Anmeldenummer: 07728229.1
(22) Anmeldetag: 18.04.2007
(51) Int. Cl.: H01L 41/053, H01L 41/083

(54) **PIEZOAKTOR MIT EINER UMMANTELUNG**
PIEZOACTUATOR WITH A CASING
PIÉZO-ACTIONNEUR COMPORTANT UN GAINAGE

(30) Priorität: 25.04.2006 DE 102006019047
(43) Veröffentlichungstag der Anmeldung: 14.01.2009
(73) Patentinhaber: Robert Bosch GmbH, 70442 Stuttgart (DE)
(72) Erfinder: SCHAICH, Udo, 70378 Stuttgart (DE); KIONTKE, Martin, 70825 Korntal-Muenchingen (DE); KOERKEMEYER, Jens, 71686 Remseck (DE)
(86) Internationale Anmeldenummer: PCT/EP2007/053767
(87) Internationale Veröffentlichungsnummer: WO 2007/122153

(56) Entgegenhaltungen:
- WO-A-01/91197
- WO-A-02/089225
- DE-A1- 10 225 408
- DE-A1- 19 914 411

## Beschreibung

Die Erfindung betrifft einen ummantelten, beispielsweise von flüssigen Medien umströmten Piezoaktor, nach den gattungsgemäßen Merkmalen des Hauptanspruchs.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors aus der DE 100 26 005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement als Stapel mehrerer elektrisch miteinander gekoppelter piezokeramischer Schichten aufgebaut, das über einen Aktorfuß und einen Aktorkopf unter Vorspannung zwischen zwei Anschlägen gehalten ist. Jede piezokeramische Schicht ist als Piezolage zwischen zwei Innenelektroden eingefasst, über die von außen eine elektrische Spannung angelegt werden kann. Aufgrund dieser elektrischen Spannung führen die piezokeramischen Schichten dann jeweils kleine Hubbewegungen in Richtung des Potentialgefälles aus, die sich zum Gesamthub des Piezoaktors addieren. Dieser Gesamthub ist über die Höhe der angelegten Spannung veränderbar und kann auf ein mechanisches Stellglied übertragen werden.

Aus der DE 102 25 408 A1 ist darüber hinaus ein Piezoaktor bekannt, der eins Hülle aus Kunststoff aufweist, die auf das Piezoelement aufgespritzt wird.

Solche bekannte Anordnungen werden häufig zur Einbringung von Kraftstoff in direkteinspritzende Dieselmotoren als so genannte Common-Rail-Systeme eingesetzt. Bei diesen als Common-Rail-Injektoren bekannten Systemen kann dabei der Einspritzdruck auf einfache Weise an die Last und Drehzahl des verbrenrtungsmotors angepasst werden.

Diese Common-Rail-Injektoren können dabei so aufgebaut werden, dass eine indirekt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist. Hierbei ist es wichtig, dass der relativ empfindliche Piezoaktor im Inneren eines Haltekörpers vor einer zu großen Druckbelastung, die in Niedcrducksystem bis zu 60 bar betragen kann, und vor einer Tcmperaturbelastung im Bereich von 40 °C bis 160 °C geschützt wird. Zusätzlich ist auch noch ein Schutz vor mechanischem Stoß oder Druck insbesondere hinsichtlich der elektrischen Isolierung notwendig.

Um eine elektrische und mechanische Isolierung des Piezoaktors zu erreichen, wird oft eine Ummantelung des Piezoaktormoduls vorgeschlagen. Aus der DE 102 30 032 A1 ist zur Vermeidung der zuvor beschriebenen Nachteile eine Anordnung mit einem Piezoaktor in umströmenden Medien bekannt, bei der die Keramikschichten des Piezoelements in einer formveränderlichen Isolationsmasse vergossen sind, die wiederum in einem seitlich und am oberen und unteren Ende gegenüber dem Medium fest verschlossenen Gehäusemantel eingebracht ist.

Für sich gesehen ist es aus einer Reihe von Anwendungen bekannt, dass mit einer elastischen Kunststoffumspritzung der Piezoaktor vor den zuvor erwähnten schädlichen Einflüssen geschützt wird. Diese erreichen den gewünschten Schutz des Piezoaktors durch eine Hülsen-Membran-Kombination. Dabei wird der Piezoaktor innerhalb einer Hülse positioniert und die offenen Enden der Hülse werden durch Schweißnähte verschlossen. Dabei sind an einem Ende (Aktorkopf) ein Stahlbauteil sowie eine Metallmembran angeordnet, wobei sich die Membran an den Hub des Piezoaktors anpasst. An dem anderen Ende befindet sich ebenfalls ein Stahlbauteil (Aktorfuß), durch das über isolierte Zuleitungen die elektrische Kontaktierung des Piezoaktors ermöglicht wird. Diese Anordnungen sind in der Regel nur sehr aufwendig und kostenintensiv zu realisieren.

### Offenbarung der Erfindung

Die Erfindung geht von einem eingangs beschriebenen Piezoaktor mit einem Piezoelement aus, das aus einem Mehrschichtaufbau von Piezolagen besteht, wobei zwischen den Piezolagen angeordnete Innenelektroden in Richtung des Lagenaufbaus des Piezoelements abwechselnd mit einer unterschiedlichen Polarität einer elektrischen Spannung beaufschlagt sind. Weiterhin ist ein mindestens die Piezolagen umgebendes in vorgegebenen Grenzen elastisches Isolationsmedium vorhanden. Erfindungsgemäß ist in vorteilhafter Weise das Piezoelement von einer elastischen Kunststoffumspritzung, vorzugsweise aus Fluorkautschuk, als Isolationsmedium umgeben und der Piezoaktor weist einen Aktorfuß und einen Aktorkopf aus Stahl auf, die jeweils mit der Kunststoffumspritzung mechanisch verbunden sind. Die mechanische Verbindung zwischen der Kunststoffumspritzung und mindestens mit dem Aktorkopf wird dabei über eine Verkrallung der aneinander liegenden Oberflächen gebildet.

Mit der Erfindung ist somit ein Verkrallen oder Verhaken der Kunststoffumspritzung mit dem Aktorkopf-/fuß über die Beißkanten von Vertiefungen, Nuten oder Bohrungen möglich. Die in der Regel benötigte homogene Wärmeabfuhr vom Piezoaktor an eine umspülende Flüssigkeit wird durch die formschlüssige Kunststoffumspritzung ebenfalls gewährleistet.

Weiterhin wird durch die natürliche Elastizität des Kunststoffes der Piezoaktor in seiner Hubbewegung nicht beschränkt. Während der Hubbewegung erfolgt eine elastische Verformung der Kunststoffumspritzung als Ummantelung, die am Ende der Hubbewegung wieder in ihren Ausgangszustand zurückkehrt. Die gewünschte elektrische Isolierung zu angrenzenden Bauteilen wird ebenfalls durch die Kunststoffumspritzung garantiert, da sie den gesamten Aktor vollständig umschließt.

Gemäß der Erfindung kann somit ein einfacher, robuster und kostengünstiger Aufbau eines Piezoaktormoduls erreicht werden, insbesondere da eine sonst übliche kompliziert zu verschweißende Hülse um den isolierten Piezoaktor, meistens aus Stahl, hier nicht mehr benötigt wird. Die Kostenersparnis wird nicht nur durch den Wegfall von Bauteilen sondern auch durch den Wegfall von Montage und Prüfschritten erzielt. Beispielsweise kann im Vergleich zu den bekannten Anordnungen das Aufpressen der Hülse auf den Aktorfuß, das Verschweißen Hülse am Aktorfuß, das Befüllen des Piezoaktormoduls mit einer 2-Komponenten-Vergussmasse zur Isolierung, die Montage einer Membran, das Befüllen des Aktormoduls mit Helium, das Verschweißung der Membran und die Heliumdichtheitsprüfung des Piezoaktormoduls entfallen. Weitere Kostenreduzierungen können auch durch die nun möglichen Maßänderungen an Aktorkopf und am Aktorfuß erzielt werden, da durch den Wegfall der Hülse diese nicht mehr auf den Aktorfuß aufgepresst werden muss. Der Pressdurchmesser kann deshalb durch ein wesentlich unkritischeres Maß ersetzt werden. In gleicher Weise kann auch am Aktorkopf der Bereich, auf dem sonst die Membran verschweißt wird, ebenfalls kostengünstiger gestaltet werden.

Gemäß einer ersten Ausführungsform kann die Verkrallung der Kunststoffumspritzung mit dem Aktorkopf vorteilhaft über mindestens eine Ringnut am Aktorkopf erfolgen, in die die Kunststoffumspritzung eingreift. Bei einer anderen Ausführungsform kann die Verkrallung der Kunststoffumspritzung mit dem Aktorkopf über eine Querbohrung im Aktorkopf erfolgen, in die sich'das Material der Kunststoffumspritzung einfügt. Weiterhin ist es auch auf einfache Weise möglich, dass die Verkrallung der Kunststoffumspritzung mit dem Aktorkopf über eine zumindest teilweise Aufrauung oder eine zumindest teilweise flächenhafte Vertiefungsstruktur der Oberfläche des Aktorkopfs erfolgt, in deren Vertiefungen sich das Material der Kunststoffumspritzung einfügt.

Bei der letztgenannten Ausführungsform kann die flächenhafte Vertiefungsstruktur der Oberfläche des Aktorkopfs beispielsweise eine Rändelung, Einbringen von Riefen oder ähnliches sein oder es kann eine Aufrauung der Oberfläche des Aktorkopfs durch eine mechanische oder chemische Oberflächenbehandlung hergestellt werden. Die mechanische Behandlung kann in vorteilhafter Weise zum Beispiel durch Sandstrahlen, Bürsten oder ähnliche mechanische Verfahren und die chemische Aufrauung durch eine Oberflächenbehandlung mit aggressiven Substanzen durchgeführt werden.

Um eine optimale mechanische Verkrallung der Kunststoffumspritzung insbesondere in axialer Richtung zu erreichen, ist erfindungsgemäß der Aktorkopf mit einem axial hinten liegenden Bund als Anlage und oder Auslaufgeometrie für die Kunststoffumspritzung auspeführt.

Bei einer bevorzugen Ausführung ist der Piezoaktor Bestandteil eines Piezoinjektors für ein Einspritzsystem für Kraftstoff bei einem Verbrennungsmotor, wobei der Kraftstoff die Kunststoffumspritzung umströmen kann. Hierbei ist somit in vorteilhafter Weise ein mechanischer Schutz des Piezoaktors vor äußerer Krafteinwirkung, wie Stoß oder Raildruck des Kraftstoffs, und auch eine bessere chemische Beständigkeit gegenüber dem Kraftstoff, wie zum Beispiel Diesel, PME, Benzin oder Wasser, auch ohne eine zusätzliche Hülse erreichbar.

In besonderer Weise ist auch verhindert, dass der Kraftstoff oder eine sonstige Flüssigkeit in Spalten zwischen dem Piezoaktor und dem Aktorfuß bzw. dem Aktorkopf eindringen kann. Weiterhin ist auch ein Schutz vor elektrischen Wechselwirkungen des Piezoaktors mit angrenzenden Bauteilen, wie zum Beispiel dem Haltekörper eines Piezoinjektors durch die vollständige und dichte Ummantelung gegeben.

Um zu gewährleisten, dass die Kunststoffumspritzung über ihre Lebensdauer keine Zersetzungserscheinungen durch den Kraftstoff bzw. mechanische Kräfte sowie Größenschwankungen durch Aufquellungen aufweist, ist der Einsatz von Fluorkautschuk statt eines bisher üblicherweise verwendeten Elastomers besonders vorteilhaft. Diese bisher verwendeten Elastomere sind teilweise durchlässig für verschiedene Kraftstoffe bzw. pflanzliches Methylester (PME), zum Beispiel Rapsmethylester, und weisen in der Regel ein ungünstiges Quellverhalten auf.

Durch die außerordentlich formschlüssige Aufbringung der Kunststoffumspritzung aus Fluorkautschuk ist es möglich, dass das Piezoaktormodul innerhalb eines Niederdruckbereichs betrieben werden kann. In Kraftstoffeinspritzsystemen werden zum Beispiel Drücke im Bereich von 60 bar erreicht, wobei die auftretende Beeinflussung durch hydraulischen Druck und dynamische Druckschwankungen in der erfindungsgemäßen Kunststoffumspritzung durch eine entsprechende elastische Verformung ausgeglichen wird.

Mit geeigneten technischen Mitteln können auf einfache Weise die hohen Anforderungen an die Umspritzung des Piezoaktors erfüllt werden, die insbesondere einen homogenen Aufbau betreffen, damit keine Lunker, Einschlüsse, Poren oder sonstige Störungen im Gefügeaufbau auftreten, die zu einer unerwünschten Rissbildung führen könnten.

Durch die elastischen Eigenschaften der erfindungsgemäßen Kunststoffumspritzung wird sichergestellt, dass der Piezoaktor nicht in seinem Hub behindert wird. Die Kunststoffumspritzung verkürzt bzw. verlängert sich dabei bei entsprechenden Aktorbewegungen. Da leicht sichergestellt werden kann, dass die Kunststoffumspritzung vollständig am Piezoaktor haftet, kann der Hub über eine Verschiebung innerhalb der Wandstärke ausgeglichen werden. Eine gute Wärmeableitung ist durch entsprechend geringe Wandstärken und durch gute Wärmeleitwerte des verwendeten Materials der Kunststoffumspritzung ebenfalls sichergestellt.

### Kurze Beschreibung der Zeichnungen

Ausführungsbeispiele des erfindungsgemäßen Piezoaktors werden anhand der Zeichnung erläutert. Es zeigen:
- Figur 1: einen Schnitt durch einen ummantelten Piezoaktor mit einem Aktorkopf und einem Aktorfuß mit einer Verkrallung des Aktorfußes an der Ummantelung,
- Figur 2: eine detaillierte Ansicht des Aktorkopfes nach der Figur 1 mit einer Ringnut zur Verkrallung der Oberflächen des Aktorfußes an der Ummantelung,
- Figur 3: eine detaillierte Ansicht des Aktorkopfes nach der Figur 1 mit einer Rändelung zur Verkrallung der Oberflächen des Aktorfußes an der Ummantelung,
- Figur 4: eine detaillierte Ansicht des Aktorkopfes nach der Figur 1 mit einer Querbohrung zur Verkrallung der Oberflächen des Aktorfußes an der Ummantelung und
- Figur 5: eine detaillierte Ansicht des Aktorkopfes nach der Figur 1 mit einer Verrauung zur Verkrallung der Oberflächen des Aktorfußes an der Ummantelung.

### Ausführungsformen der Erfindung

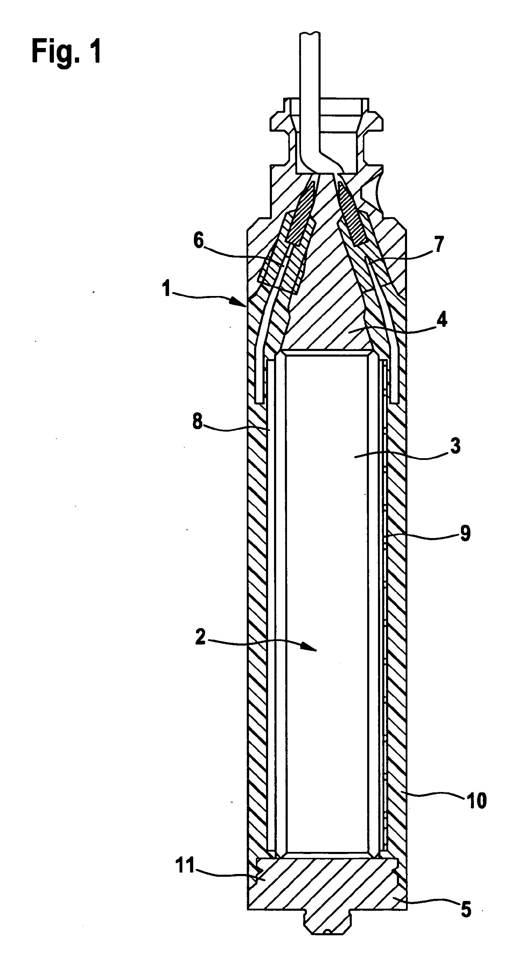

In Figur 1 ist eine Anordnung 1 mit einem Piezoaktor 2 gezeigt, die beispielsweise zur Nadelhubsteuerung im Einspritzsystem für Kraftstoff bei einem Verbrennungsmotor eingesetzt werden kann. Ein Piezoelement 3 ist Bestandteil des Piezoaktors 2, der weiterhin noch einen Aktorfuß 4 und einen Aktorkopf 5 aus Stahl aufweist. Es sind elektrische Zuleitungen 6 und 7 durch den Aktorfuß 4 geführt, die über Außenelektroden 8 und 9 an hier nicht dargestellten Innenelektroden im Piezoelement 3 kontaktiert sind. Bei einer Betätigung des Piezoaktors 2 durch eine Spannungsbeaufschlagung der Innenelektroden kann eine hier senkrecht unterhalb des Aktorkopfes 5 befindliche mechanische Anordnung derart betätigt werden, dass hier eine Freigabe einer Düsenöffnung des Einspritzsystems erfolgen kann.

Die Anordnung 1 mit dem Piezoaktor 2 ist in einem hier nicht gezeigten Injektorkörper eingebaut, wobei der Kraftstoff durch den Innenraum des Injektorkörpers an der Anordnung 1 vorgeigeführt wird. Dieser Kraftstoff kann dann beispielsweise bei einem sogenannten Common-Rail-System unter dem in der Beschreibungseinleitung erwähnten Raildruck oder einem anderen vorgebbaren Druck in den Brennraum eines hier nicht dargestellten Verbrennungsmotors injiziert werden.

Um den Piezoaktor 2 vor dem umströmenden Kraftstoff und vor sonstigen schädlichen Einwirkungen zu schützen, ist eine Kunststoffumspritzung 10, hier aus Fluorkautschuk, vorhanden, die insbesondere das empfindliche Piezoelement 3 fest umschließt und außerdem mit dem Aktorkopf 5 über eine unten noch näher erläuterte Verkrallung 11 bei der Montage verbunden ist.

Um diese Ummantelung aus Fluorkautschuk auf den Piezoaktor 2 aufzubringen, können zum Beispiel folgende Montageschritte durchgeführt werden: Der Piezoaktor 2 wird mit dem Aktorfuß 4 und dem Aktorkopf 5 auf einer plan geschliffenen Auflagefläche positioniert um die Aufnahme der entstehenden Aktorkräfte und deren Übertragung auf angrenzende Bauteile zu ermöglichen. Eine direkte Übertragung der Kräfte durch den Piezoaktor 2 ist nicht möglich, da der Piezoaktor 2 sehr empfindlich ist und an die Kontaktstellen hohe Anforderungen gestellt werden. Weiterhin muss eine elektrische Kontaktierung des Piezoaktors 2 ermöglicht werden, wobei der Piezoaktor 2 mit dem Aktorfuß 4 und dem Aktorkopf 5 an den Berührungsflachen zunächst mit Klebstoff fixiert werden kann, um eine Erleichterung der nachfolgenden Arbeitsschritte zu erreichen.

Um die Funktionsfähigkeit der Kunststoffumspritzung 10, als Ummantelung zu gewährleisten, ist es notwendig angrenzende Bauteile mit geeigneten Geometrien zu versehen. Dazu gehört auch eine hydraulisch druckgünstige Auslegung, um dem Kraftstoff oder dem Kraftstoffgemisch so wenig Angriffsfläche wie möglich zu bieten. Dies ist notwendig, um ein Ablösen der Kunststoffumspritzung 10 von den Stahlbauteilen des Aktorfußes 4 und dem Aktorkopf 5 bzw. dem Piezoelement 3 zu verhindern.

Weiterhin wird erfindungsgemäß vorgeschlagen, die Oberfläche des Aktorfußes 4 und des Aktorkopfs 5, an denen die Kunststoffumspritzung 10 haften soll, mit den geeigneten Verkrallungen 11 bzw. Beißkanten zu versehen. Diese dienen ebenfalls auch dem Zweck, ein mögliches Ablösen zu verhindern.

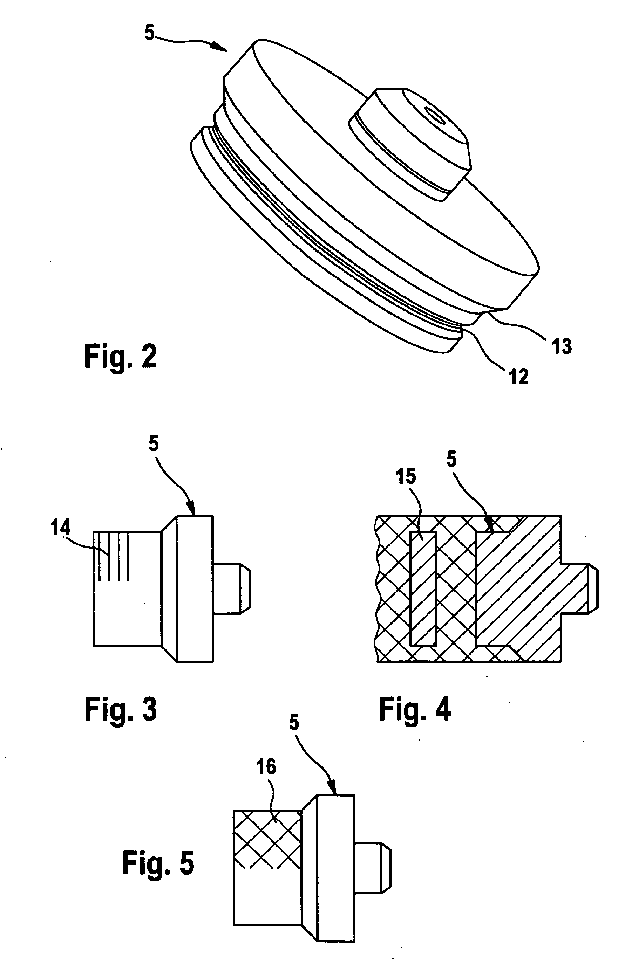

Aus Figur 2 ist der Aktorfuß 5 im Detail zu entnehmen, wobei hier eine Ringnut 12 als Element zur Gestaltung der Verkrallung 11 nach der Figur 1 vorgesehen ist. Ferner ist auch ein Bund 13 als Anlage und Auslaufgeometrie für die Kunststoffumspritzung 10 nach der Figur 1 zu erkennen.

Figur 3 zeigt ein anderes Ausführungsbeispiel der Verkrallung 11 mit einer Rändelung 14 auf dem Umfang der Oberfläche des Aktorfußes 5 zur Verkrallung der Kunststoffumspritzung 10 nach der Figur 1.

In Figur 4 ist ein Ausführungsbeispiel mit einer Querbohrung 15 im Aktorkopf 5 gezeigt, in die sich das Material der Kunststoffumspritzung 10 einfügt.

Außerdem ist noch aus Figur 5 ein Ausführungsbeispiel zu entnehmen, bei dem über eine zumindest teilweise Aufrauung 16 oder eine zumindest teilweise flächenhafte Vertiefungsstruktur der Oberfläche des Aktorkopf 5 die Verkrallung 11 erfolgt, wobei sich in die Vertiefungen der mechanisch oder chemisch erzeugten Aufrauungen das Material der Kunststoffumspritzung 10 einfügt.

Ein mit den erläuterten Ausführungsbeispielen gestaltetes Modul mit dem Piezoaktor 2 kann nun im Spritzgussverfahren mit einer Fluorkautschukummantelung als Kunststoffumspritzung 10 gemäß der Figur 1 versehen werden. Die Außengeometrie der Kunststoffumspritzung 10 kann dabei an die jeweiligen Anforderungen beliebig angepasst werden, insbesondere in Bezug auf die Geometrie der verwendeten Piezoaktoren, dem Konzept der Wärmeableitung oder dem zur Verfügung stehenden Einbauraum im Haltekörper des zuvor erwähnten Piezoinjektors.

## Patentansprüche

1. Piezoaktor (2) mit einem Piezoeleftient (3) , bestehend aus einem Mehrschichtaufbau von Piezolagen, wobei zwischen den Piezolagen angeordnete Innenelektroden in Richtung des Lagenaufbaus des Piezoelements (3) abwechselnd mit einer unterschiedlichen Polarität einer elektrischen Spannung beaufschlagt sind und mit einem mindestens die Piezolagen umgebenden elastischen Isolationsmedium (10), wobei das Piczoelement (3) von einer elastischen Kunststoffumspritzung (10) als Isolationsmedium umgeben ist und der Piezoaktor (2) einen Aktorfuß (4) und einen Aktorkopf (5) aufweist, die vorzugsweise aus stahl gefertigt sind und die jeweils mit der Kunststoffumspritzung (10) mechanisch verbunden sind, und die Verbindung zwischen der Kunststoftumspritzung (10) und mindestens dem Aktorkopfs (5) über eine Verkrallung (11) der aneinander liegenden Oberflächen gebildet ist, **dadurch gekennzeichnet, dass** der Aktorkopf (5) einen axial hinten liegenden Bund (13) als Anlage und/oder Auslaufgeometrie für die KunststoffuLusprit-zung (10) aufweist.

2. Piezoaktor nach Anspruch 1, **dadurch gekennzeichnet, dass** die Kunststoffumspritzung (10) aus Fluorkautschuk gebildet ist.

3. Piezoaktor nach Anspruch 1 oder 2, **dadurch gekennzeichnet,** das die verkrallung (11) der Kurstotoffumspritzung (10) mit dem Aktorkopf (5) über mindestens eine Ringnut (12) am Aktorkopf (5) erfolgt, in die die Kunststoffumspritzung (10) eingreift.

4. Piezoaktor nach Anspruch 1 oder 2, **dadurch gekennzeichnet, dass** die verkrallung (11) der Kunststoffumspritzung (10) mit dem Aktorkopf (5) über eine Querbohrung (15) im Aktorkopf (5) erfolgt, in die sich das Material der Kunststoffumspritzung (10) einfügt.

5. Piezoaktor nach Anspruch 1 oder 2, **dadurch gekennzeichnet, dass** die Verkrallung (11) der Kunststoffumspritzung (10) mit dem Aktorkopf (5) über eine zumindest teilweise Aufrauung (16) oder eine zumindest teilweise flächenhafte Vertiefungsstruktur der Oberfläche des Aktorkopfs (5) erfolgt, in deren Vertiefungen sich das Material der Kunstztoffumspritzung (10) einfügt.

6. Piezoaktor nach Anspruch 5, **dadurch gekennzeichnet, dass** die flächenhafte Vertiefungsstruktur der Oberfläche des Aktorkopfs (5) eine Rändelung (14) ist.

7. Piezoaktor nach Anspruch 5, **dadurch gekennzeichnet, dass** die Aufrauung (16) der Oberfläche des Aktorkopfs (5) durch eine mechanische Oberflächenbehandlung hergestellt ist.

8. Piezoaktor nach Anspruch 5, **dadurch gekennzeichnet, dass** die Aufraüung (16) der Oberfläche des Aktorkopfs (5) durch eine chemische Oberflächenbehandlung hergestellt ist.

9. Piezoaktor nach einem der vorhergehenden Ansprüche, **dadurch gekennzeichnet, dass** der Piezoaktor (2) Bestandteil eines Piezoinjektors in einem Einspritzsystem für Kraftstoff in einem Verbrennungsmotor ist, wobei der Kraftstoff die Kunststoffumspritzung (10) umströmt.

## Claims

1. Piezo actuator (2) having a piezo element (3) composed of a multi-layer structure of piezo layers, wherein inner electrodes arranged between the piezo layers are acted on in the direction of the layer structure of the piezo element (3) alternately with a varying polarity of an electrical voltage, and having an elastic insulation medium (10) which surrounds at least the piezo layers, wherein the piezo element (3) is surrounded by an elastic plastic encapsulation (10) as an insulation medium, and the piezo actuator (2) has an actuator foot (4) and an actuator head (5) which are preferably produced from steel and which are in each case mechanically connected to the plastic encapsulation (10), and the connection between the plastic encapsulation (10) and at least the actuator head (5) is formed by means of an interlocking (11) of the surfaces which bear against one another, **characterized in that** the actuator head (5) has a collar (13), situated axially at the rear, as an abutment and terminating geometry for the plastic encapsulation (10).

2. Piezo actuator according to Claim 1, **characterized in that** the plastic encapsulation (10) is formed from fluororubber.

3. Piezo actuator according to Claim 1 or 2, **characterized in that** the interlocking (11) of the plastic encapsulation (10) with the actuator head (5) is realized by means of at least one annular groove (12) on the actuator head (5), into which the plastic encapsulation (10) engages.

4. Piezo actuator according to Claim 1 or 2, **characterized in that** the interlocking (11) of the plastic encapsulation (10) with the actuator head (5) is realized by means of a transverse bore (15) in the actuator head (5), into which the material of the plastic encapsulation (10) penetrates.

5. Piezo actuator according to Claim 1 or 2, **characterized in that** the interlocking (11) of the plastic encapsulation (10) with the actuator head (5) is realized by means of an at least partial roughened portion (16) or an at least partially areal depression structure on the surface of the actuator head (5), into the depressions of which the material of the plastic encapsulation (10) penetrates.

6. Piezo actuator according to Claim 5, **characterized in that** the areal depression structure of the surface of the actuator head (5) is a knurling (14).

7. Piezo actuator according to Claim 5, **characterized in that** the roughened portion (16) of the surface of the actuator head (5) is produced by means of a mechanical surface treatment process.

8. Piezo actuator according to Claim 5, **characterized in that** the roughened portion (16) of the surface of the actuator head (5) is produced by means of a chemical surface treatment process.

9. Piezo actuator according to one of the preceding claims, **characterized in that** the piezo actuator (2) is a constituent part of a piezo injector in an injection system for fuel in an internal combustion engine, wherein the fuel flows around the plastic encapsulation (10).

## Revendications

1. Piézoactionneur (2) comprenant un élément piézoélectrique (3), constitué d'une structure multicouche de couches piézoélectriques, des électrodes internes disposées entre les couches piézoélectriques étant sollicitées dans la direction de la structure stratifiée de l'élément piézoélectrique (3) en alternance avec une polarité différente d'une tension électrique et comprenant un milieu isolant élastique (10) entourant au moins les couches piézoélectriques, l'élément piézoélectrique (3) étant entouré par un surmoulage en plastique élastique (10) en tant que milieu isolant et le piézoactionneur (2) présentant une base d'actionneur (4) et une tête d'actionneur (5), qui sont de préférence fabriquées en acier, et qui sont connectées mécaniquement à chaque fois par le surmoulage en plastique (10), et la connexion entre le surmoulage en plastique (10) et au moins la tête d'actionneur (5) étant formée par un emboîtement (11) des surfaces en contact l'une avec l'autre, **caractérisé en ce que** la tête d'actionneur (5) présente un épaulement (13) situé axialement en arrière en tant qu'appui et/ou une géométrie de sortie pour le surmoulage en plastique (10).

2. Piézoactionneur selon la revendication 1, **caractérisé en ce que** le surmoulage en plastique (10) est formé en caoutchouc fluoré.

3. Piézoactionneur selon la revendication 1 ou 2, **caractérisé en ce que** l'emboîtement (11) du surmoulage en plastique (10) avec la tête d'actionneur (5) s'effectue par le biais d'au moins une rainure annulaire (12) au niveau de la tête d'actionneur (5), dans laquelle rainure annulaire vient en prise le surmoulage en plastique (10).

4. Piézoactionneur selon la revendication 1 ou 2, **caractérisé en ce que** l'emboîtement (11) du surmoulage en plastique (10) avec la tête d'actionneur (5) s'effectue par le biais d'un alésage transversal (15) dans la tête d'actionneur (5), dans lequel s'insère le matériau du surmoulage en plastique (10).

5. Piézoactionneur selon la revendication 1 ou 2, **caractérisé en ce que** l'emboîtement (11) du surmoulage en plastique (10) avec la tête d'actionneur (5) s'effectue par le biais d'une rugosification au moins partielle (16) ou d'une structure de renfoncement de surface au moins partielle de la surface de la tête d'actionneur (5), dans les renfoncements de laquelle s'insère le matériau du surmoulage en plastique (10).

6. Piézoactionneur selon la revendication 5, **caractérisé en ce que** la structure de renfoncement de surface de la surface de la tête d'actionneur (5) est un moletage (14).

7. Piézoactionneur selon la revendication 5, **caractérisé en ce que** la rugosification (16) de la surface de la tête d'actionneur (5) est fabriquée par un traitement de surface mécanique.

8. Piézoactionneur selon la revendication 5, **caractérisé en ce que** la rugosification (16) de la surface de la tête d'actionneur (5) est fabriquée par un traitement de surface chimique.

9. Piézoactionneur selon l'une quelconque des revendications précédentes, **caractérisé en ce que** le piézoactionneur (2) fait partie d'un injecteur piézoélectrique dans un système d'injection pour carburant dans un moteur à combustion interne, le carburant circulant autour du surmoulage en plastique (10).
